Europäisches Patentamt

European Patent Office

Office européen des brevets

(19)

(11) Veröffentlichungsnummer: **0 263 942**
**A1**

## (12) EUROPÄISCHE PATENTANMELDUNG

(21) Anmeldenummer: 87111910.3

(22) Anmeldetag: 17.08.87

(51) Int. Cl.⁴ **H01J 37/244**

(30) Priorität: 10.10.86 DE 3634638

(43) Veröffentlichungstag der Anmeldung:
20.04.88 Patentblatt 88/16

(84) Benannte Vertragsstaaten:
DE FR GB IT NL

(71) Anmelder: **Siemens Aktiengesellschaft Berlin**
**und München**
**Wittelsbacherplatz 2**
**D-8000 München 2(DE)**

(72) Erfinder: **Frosien, Jürgen, Dr.-Ing.**
**An der Ottosäule 16**
**D-8012 Ottobrunn(DE)**
Erfinder: **Plies, Erich, Dr.rer.nat.**
**Firlestrasse 15**
**D-8000 München 83(DE)**
Erfinder: **Weyl, Reinhard, Dr.rer.nat.**
**Waldstrasse 16**
**D-8019 Assling(DE)**

(54) **Spektrometer-Detektoranordnung für quantitative Potential-messungen.**

(57) Die erfindungsgemäße Spektrometer-Detektoranordnung besteht im wesentlichen aus einem elektrostatischen Gegenfeldspektrometer (SP) und einem unmittelbar oberhalb des Spektrometers (SP) konzentrisch zur Strahlachse (OA) angeordneten Halbleiterdetektor (DT). Der ringförmige Halbleiterdetektor (DT) ist segmentiert aufgebaut, wobei die teilchensensitiven Bereiche (ES) symmetrisch zur Strahlachse (OA) angeordnet und vorzugsweise als Metall-Halbleiter-Übergang oder p-n-Übergang ausgebildet sind.

FIG 1

FIG 2

EP 0 263 942 A1

## Spektrometer-Detektoranordnung für quantitative Potentialmessungen

Die Erfindung betrifft eine Spektrometer-Detektoranordnung für quantitative Potentialmessungen nach dem Oberbegriff des Patentanspruchs 1.

Die Funktionsweise mikroelektronischer Bauelemente wird üblicherweise in rechnergesteuerten Testsystemen durch die Analyse der an den Ausgängen der Schaltung gemessenen Signale überprüft. Die so durchgeführten Tests sind allerdings in den meisten Fällen unvollständig, da fehlerhafte Bausteinkomponenten nur sehr schwer innerhalb der hochkomplexen Strukturen lokalisiert werden können. Deshalb ist man insbesondere im Bereich der Entwicklung und Fertigung mikroelektronischer Bauelemente gezwungen zusätzliche Messungen im Innern der Schaltungen durchzuführen. Besonders aufschlußreiche Hinweise zur Lokalisierung fehlerhafter Bausteinkomponenten erhält man hierbei durch Messungen des zeitlichen Signalverlaufes an internen Knotenpunkten und Leiterbahnen.

Quantitative Potentialmessungen werden gegenwärtig mit Hilfe modifizierter Rasterelektronenmikroskope durchgeführt, in denen man die vom Potential des Meßpunktes abhängige Verschiebung der Energieverteilung der von einem primären Elektronenstrahl ausgelösten Sekundärelektronen mit einer Spektrometer-Detektoranordnung bestimmt. Eine solche Spektrometer-Detektoranordnung ist beispielsweise aus der Veröffentlichung von H. P. Feuerbaum "VLSI testing using the electron probe" SEM/1979/I Seite 285 bis 296 bekannt. Die bekannte Anordnung besteht im wesentlichen aus einer Absaugelektrode, einer ebenen Gegenfeldelektrode und einer Ablenkeinheit zur Beschleunigung der Sekundärelektronen in Richtung eines seitlich oberhalb der Probe angeordneten Detektors. Aufgrund des unsymmetrischen Aufbaus dieser Anordnung kann man allerdings nur einen Teil der Sekundärelektronen mit Energien oberhalb der im Spektrometer aufgebauten Potentialbarriere nachweisen, da insbesondere die auf detektorfernen Bahnen laufenden Elektronen nur schwach abgelenkt werden.

Der Erfindung liegt die Aufgabe zugrunde, eine Spektrometer-Detektor-Anordnung der eingangs genannten Art anzugeben, mit der nahezu alle Sekundärelektronen mit kinetischen Energien oberhalb der im Spektrometer aufgebauten Potentialbarriere nachgewiesen werden können. Es sollen insbesondere Potentialmessungen mittels Sekundärelektronen möglich sein, die die Probe in bestimmten Raumrichtungen verlassen.

Diese Aufgabe wird erfindungsgemäß durch eine Spektrometer-Detektoranordnung der eingangs genannten Art gelöst, durch die kennzeichnenden Merkmale des Patentanspruchs 1 aufweist.

Der mit der erfindungsgemäßen Spektrometer-Detektoranordnung erzielbare Vorteil besteht insbesondere darin, daß das Signal-Rausch-Verhältnis und damit die Auflösung bei quantitativen Potentialmessungen deutlich gesteigert werden kann.

Die Ansprüche 2 bis 11 sind auf bevorzugte Ausgestaltungen und Weiterbildungen der Erfindung gerichtet.

Die Erfindung wird nachfolgend anhand der Zeichnungen erläutert.

Dabei zeigt:

Fig. 1 ein bevorzugtes Ausführungsbeispiel einer erfindungsgemäßen Spektrometer-Detektoranordnung

Fig. 2 den Sekundärelektronendetektor der Anordnung nach Fig. 1

Trifft ein Elektronenstrahl auf eine Probe, so werden aufgrund der Wechselwirkung der Primärteilchen mit der Festkörpersubstanz Sekundärelektronen emittiert, deren Energie-und Winkelverteilung u. a. von der im Wechselwirkungsbereich vorliegenden chemisch-pyhsikalischen Zusammensetzung, der Oberflächenstruktur und der auf der Probe vorhandenen Potentialverteilung beeinflußt wird. Von besonderer Bedeutung für die Überprüfung der Funktionsweise mikroelektronischer Bauelemente ist hierbei der als Potentialkontrast bezeichnete und mittels einer Spektrometer-Detektoranordnung quantitativ erfaßbare Einfluß elektrischer Felder auf die Energieverteilung der emittierten Sekundärelektronen (siehe beispielsweise die eingangs zitierte Veröffentlichung von H. P. Feuerbaum).

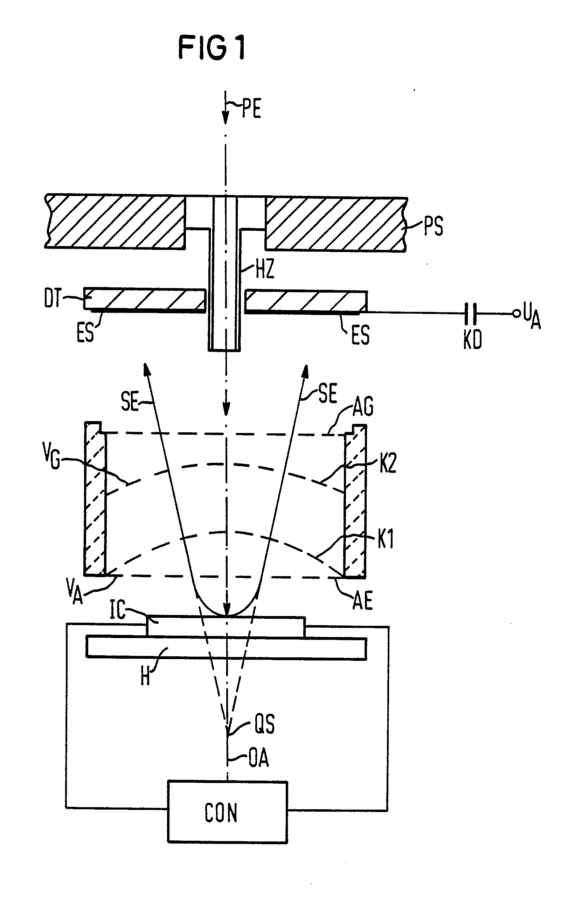

Das in Fig. 1 dargestellte elektrostatische Gegenfeldspektrometer SP zur Bestimmung der vom Probenpotential abhängigen Verschiebung der Energieverteilung der von einem primären Elektronenstrahl PE ausgelösten Sekundärelektronen SE besteht im wesentlichen aus einer auf positivem Potential $V_A$ liegenden ebenen Absaugelektrode AE, einer ein kugelsymmetrisches Gegenfeld erzeugenden Elektrodenanordnung K1/K2 und einem oberhalb der jeweils kugelsymmetrischen Elektroden K1 bzw. K2 angeordneten Abschirmgitter AG. Diese Elektroden sind vorzugsweise netzartig ausgebildet und erlauben den Durchtritt der entlang der Strahlachse OA in das Spektrometer SP eintretenden Primärelektronen PE. Den primären Elektronenstrahl PE erzeugt man vorzugsweise in einem in Fig. 1 nicht dargestellten Elektronenstrahlmeßgerät, dessen elektronenoptische Säule im wesentlichen aus einer Elektronenkanone, einem Strahlaustastsystem, einer Ablenkeinheit und einem Linsensystem zur Fokussierung des Strahls auf einen nicht näher bezeichneten Meßpunkt der Probe IC besteht. Als Probe IC ist vorzugsweise eine auf einer Halterung H angeordnete und relativ zum primären Elektronenstrahl PE ausgerichtete hochintegrierte Schaltung vorgesehen, in die man geeignete Testprogramme über eine Ansteuerung CON einspeist. Entsprechend der Schaltungsstruktur der Probe IC treten dann während des Testzyklus charakteristische, den jeweiligen Betriebszustand definierende Signale an Knotenpunkten und Leiterbahnen auf, deren Zeitverhalten beispielsweise mit Hilfe eines Sampling-Verfahrens aufgezeichnet und mit den aus Simulationsrechnungen gewonnenen Signalverläufen verglichen werden kann.

Zur Unterdrückung elektrischer Nahfelder auf der Probenoberfläche legt man die Elektrode AE auf ein hohes positives Potential $V_A$ zwischen etwa 0,5 und 5 kV, wodurch die ausgelösten Sekundärelektronen SE in einem starken elektrischen Feld abgesaugt und in Richtung der Strahlachse OA beschleunigt werden. Die hochenergetischen Sekundärelektronen SE durchlaufen die unmittelbar oberhalb der Probe IC angeordnete Absaugelektrode AE und gelangen in das zwischen den auf unterschiedlichem Potential $V_A$ bzw. $V_G$ liegenden Gitterelektroden K1 und K2 aufgebaute kugelsymmetrische elektrische Gegenfeld. Die Höhe der im Spektrometer SP aufgebauten Potentialbarriere, die den im Detektor DT nachweisbaren Sekundärelektronenstrom begrenzt, wird hierbei mit Hilfe der an der Gegenfeldelektrode K2 anliegenden Spannung $V_G$ derart eingestellt, daß die von lokalen elektrischen Feldern an der Probenoberfläche stark beeinflußten niederenergetischen Sekundärelektronen nicht zum Meßsignal beitragen. Die äußere Elektrode K2 wird deshalb üblicherweise mit Spannungen $V_G$ zwischen etwa + 15 und -15 Volt beaufschlagt, während die innere Elektrode K1 auf dem Potential $V_A$ der Absaugelektrode AE liegt.

Um eine vom Emissionswinkel (Winkel den der Geschwindigkeitsvektor der Sekundärelektronen mit der Strahlachse OA einschließt) unabhängige Energieanalyse der Sekundärelektronen SE zu gewährleisten, wird das durch den gemeinsamen Mittelpunkt der Gitterelektroden K1 und K2 definierte Zentrum des kugelsymmetrischen Gegenfeldes in den virtuellen Quellpunkt QS der Sekundärelektronen SE gelegt. Hierdurch ist eine vom Emissionswinkel unabhängige also isotrope Abbremsung der Sekundärelektronen SE möglich, da deren Geschwindigkeitsvektor $v_{SE}$ im elektrischen Gegenfeld immer parallel zum Feldverstärkevektor E orientiert ist.

Zum Nachweis der aus dem Abschirmgitter AG austretenden Sekundärelektronen SE ist ein unmittelbar oberhalb des Spektrometers SP konzentrisch zur Strahlachse OA angeordneter Halbleiterdetektor DT vorgesehen, der vorzugsweise ringförmig ausgebildet ist und einen in die Ausnehmung eingepaßten Hohlzylinder HZ als Abschirmung des primären Elektronenstrahles PE gegenüber der am Detektor DT anliegenden Hochspannung von beispielsweise + 10 kV aufweist. Der ebenfalls konzentrisch zur Strahlachse OA angeordnete Hohlzylinder HZ wird hierbei vorzugsweise im Bereich der unteren Polschuhe PS der abbildenden Linse des Elektronenstrahlmeßgerätes gehalten. Halbleiterdetektoren zum Nachweis geladener Teilchen sind dem Fachmann beispielsweise aus der Veröffentlichung von W. K. Hofker "Halbleiterdetektoren für ionisierende Strahlung", Philips Technische Rundschau Nr. 12, 1966, Seite 323 bis 337 bekannt, so daß im folgenden nicht mehr auf den prinzipiellen Aufbau, die Wirkungsweise und die Eigenschaften solcher Detektoren eingegangen werden muß. Erfindungsgemäß ist der Halbleiterdetektor DT segmentiert aufgebaut, wobei die teilchensensitiven Bereiche ES symmetrisch zur Strahlachse OA angeordnet und vorzugsweise als Metall-Halbleiter-Übergang oder p-n-Übergang ausgebildet sind. Die auf ein in konventioneller Weise verschaltetes Detektorsegment ES auftreffenden hochenergetischen Sekundärelektronen SE ($E_{SE}$ 10 kV) erzeugen ein Ausgangssignal $U_A$, das man beispielsweise in einer aus der eingangs zitierten Veröffentlichung von H. P. Feuerbaum (insbesondere Seite 289, Fig. 4) bekannten Meßkette weiterverarbeiten kann. Dieser Meßkette ist vorteilhafterweise ein Kondensator KD vorgeschaltet, der das auf hohem Potential liegende Meßsignal auf erdnahes Potential transferiert. Anstelle des in Fig. 1 dargestellten Kondensators KD kann man selbstverständlich auch ein Trenntrafo oder ein Optokoppler verwenden.

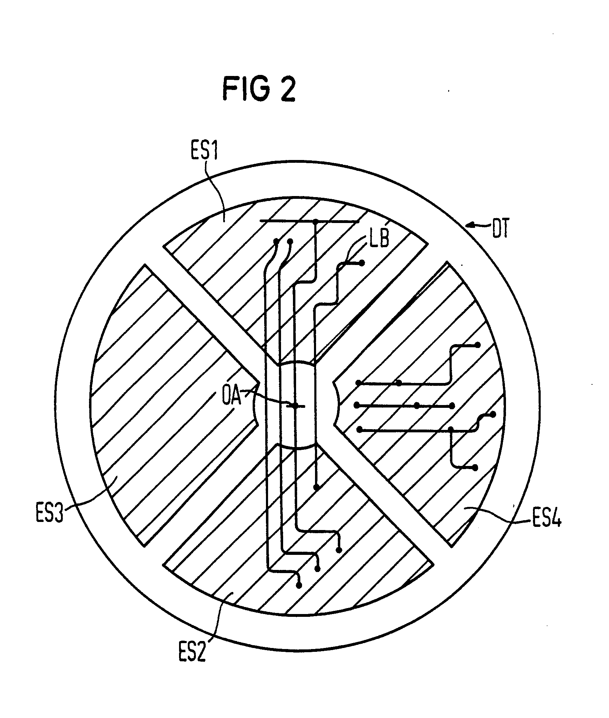

Ein bevorzugtes Ausführungsbeispiel eines erfindungsgemäßen Halbleiterdetektors ist schematisch in Fig. 2 dargestellt. Der ringförmige Detektor DT besteht aus vier symmetrisch zur Strahlachse OA angeordneten teilchensensitiven Bereichen ES1 bis ES4, die sektorartig ausgebildet und in dem gezeigten Ausführungsbeispiel paarweise parallel (ES1, ES2) bzw. senkrecht (ES3, ES4) zu den Leiterbahnen LB der untersuchten Schaltung ausgerichtet sind. Der segmentierte Aufbau des Detektors DT ermöglicht Potentialmessungen mittels Sekundärelektronen SE, die die Probe IC in bestimmten Raumrichtungen verlassen. Es ist bekannt, daß elektrische Nahfelder, welche beispielsweise von benachbarten Leiterbahnen erzeugt werden, die Winkelverteilung der an einem Meßpunkt ausgelösten Sekundärelektronen SE beeinflussen.

Diese Nahfeldeinflüsse können in der erfindungsgemäßen Spektrometer-Detektoranordnung meßtechnisch zumindest teilweise kompensiert werden, in dem man die Ausgangssignale der senkrecht zu vermessenden Leiterbahn orientierten Detektorsegment ES3 und ES4 beispielsweise mit Hilfe einer Schalteranordnung unterdrückt und nur die weit weniger von elektrischen Nahfeldern beeinflußten Ausgangssignale der parallel zur Leiterbahn orientierten Detektorsegmente ES1 und ES2 verstärkt und der Meßkette zuführt. Im allgemeinen muß allerdings experimentiell festgestellt werden, welche Signalbeiträge der einzelnen Detektorsegmente ES ein optimales Meßergebnis für einen gegebenen Prüfpunkt liefern.

Die erfindungsgemäße Spektrometer-Detektoranordnung kann selbstverständlich auch in die Objektivlinse eines Korpuskularstrahlgerätes integriert werden. Hierbei muß allerdings sichergestellt sein, daß die auf der Probe ausgelösten und von der Absaugelektrode AE beschleunigten Sekundärelektronen im Magnetfeld der Objektivlinse in das auf der Strahlachse OA in einem feldfreien Raum liegende Zentrum des kugelsymmetrischen Gegenfeldes fokussiert werden. Das Gegenfeldspektrometer und der Detektor können hierbei vollständig innerhalb oder unmittelbar oberhalb der Objektivlinse angeordnet werden.

Die kugelsymmetrischen Elektroden K1 und K2 kann man selbstverständlich auch durch eine andere, beispielsweise ebene Elektrodenkonfiguration ersetzen. In einer solchen Anordnung ist allerdings kein vom Emissionswinkel unabhängiger Nachweis der Sekundärelektronen möglich.

## Ansprüche

1. Spektrometer-Detektoranordnung für quantitative Potentialmessungen mit einem Gegenfeldspektrometer zur Energieanalyse der von einem entlang einer Strahlachse geführten primären Teilchenstrahl auf einer Probe ausgelösten Sekundärteilchen und einem Detektor zum Nachweis der Sekundärteilchen, **gekennzeichnet** durch einen unmittelbar oberhalb des Spektrometers (SP) konzentrisch zur Strahlachse (OA) angeordneten Halbleiterdetektor (DT) der mehrere, symmetrisch zur Strahlachse (OA) angeordnete teilchensensitive Bereiche (ES) aufweist.

2. Spektrometer-Detektoranordnung nach Anspruch 1, **gekennzeichnet** durch eine gerade Anzahl teilchensensitiver Bereiche (ES).

3. Spektrometer-Detektoranordnung nach Anspruch 1 oder 2, dadurch **gekennzeichnet**, daß die teilchensensitiven Bereiche (ES) Sektoren eines Kreises bilden.

4. Spektrometer-Detektoranordnung nach einem der Ansprüche 1 bis 3, dadurch **gekennzeichnet**, daß der Detektor DT ringförmig ausgebildet ist.

5. Spektrometer-Detektoranordnung nach einem der Ansprüche 1 bis 4, dadurch **gekennzeichnet**, daß die teilchensensitiven (ES) durch einen Metall-Halbleiter-Übergang gebildet werden.

6. Spektrometer-Detektoranordnung nach einem der Ansprüche 1 bis 4, dadurch **gekennzeichnet**, daß die teilchensensitiven Bereiche durch einen p-n-Übergang gebildet werden.

7. Spektrometer-Detektoranordnung nach einem der Ansprüche 1 bis 6, dadurch **gekennzeichnet**, daß der Detektor (DT) einen konzentrisch zur Strahlachse (OA) angeordneten Hohlzylinder (HZ) als Abschirmung aufweist.

8. Spektrometer-Detektoranordnung nach einem der Ansprüche 1 bis 7, dadurch **gekennzeichnet**, daß das Spektrometer SP eine auf einem ersten Potential ($V_A$) liegende Absaugelektrode (AE) und eine auf einem zweiten Potential ($V_G$) liegende Gegenfeldelektrode (K2) aufweist.

9. Spektrometer-Detektoranordnung nach einem der Ansprüche 1 bis 7, dadurch **gekennzeichnet**, daß das Spektrometer SP eine Absaugelektrode AE und zwei kugelsymmetrische Elektroden (K1, K2) aufweist, deren Potentiale ($V_A$, $V_G$) so gewählt sind, daß sich im Raumbereich zwischen diesen Elektroden ein kugelsymmetrisches Gegenfeld aufbaut, und daß die Mittelpunkte der kugelsymmetrischen Elektroden (K1, K2) in einem auf der Strahlachse (OA) liegenden Punkt (QS) zusammenfallen.

10. Spektrometer-Detektoranordnung nach Anspruch 9, dadurch **gekennzeichnet**, daß der Mittelpunkt der kugelsymmetrischen Elektroden (K1, K2) im virtuellen Quellpunkt (QS) der Sekundärteilchen (SE) liegt.

11. Spektrometer-Detektoranordnung nach Anspruch 9, dadurch **gekennzeichnet**, daß der Mittelpunkt der kugelsymmetrischen Elektroden (K1, K2) in einem Fokus der Sekundärteilchen (SE) liegt.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 6, Nr. 6 (E-89)[884], 14. Januar 1982; & JP-A-56 126 933 (NIPPON DENSHIN DENWA KOSHA) 05-10-1981 --- | 1-4 | H 01 J 37/244 |
| A | US-A-4 551 625 (B. LISCHKE et al.) * Spalte 3, Zeilen 12-29; Figur 3 * --- | 1 | |
| A | PATENT ABSTRACTS OF JAPAN, Band 9, Nr. 193 (E-334)[1916], 9. August 1985; & JP-A-60 62 048 (SEIKO DENSHI KOGYO K.K.) 10-04-1985 --- | 1-5 | |
| A,D | SCANNING ELECTRON MICROSCOPY, 1979/I, Seiten 285-296, Amf O'Hare, US; H.P. FEUERBAUM: "VLSI testing using the electron probe" * Seiten 288-290; Figur 4 * --- | | |
| A,D | PHILIPS TECHNISCHE RUNDSCHAU, Nr. 12, 1966, Seiten 323-337; W.K. HOFKER: "Halbleiterdetektoren für ionisierende Strahlung" * Zusammenfassung * --- | 1 | RECHERCHIERTE SACHGEBIETE (Int. Cl.4) |
| A | US-A- 85 896 (EURATOM) * Seite 1, Abschnitt 2, Zeile 3; Seite 2, Abschnitt 2, Zeilen 1,2; Figur 3 * ----- | 1 | H 01 J 37/00 G 01 R 31/00 |

Der vorliegende Recherchenbericht wurde für alle Patentansprüche erstellt

| Recherchenort | Abschlußdatum der Recherche | Prüfer |
|---|---|---|
| DEN HAAG | 11-01-1988 | WITH F.B. |